# EUROPEAN PATENT APPLICATION

(11) **EP 4 807 975 A1**
(43) Date of publication of application: **16.09.2026**
(21) Application number: 26162332.6
(22) Date of filing: 04.03.2026
(51) Int. Cl.: H02M 7/5387, H02M 3/00, H02M 7/00, H01H 50/12, H05K 1/02, H05K 7/20

(54) **POWER CONVERTER AND RELAY HEAT DISSIPATION APPARATUS**

(30) Priority: 10.03.2025 CN 202510280212; 09.12.2025 CN 202511850696
(71) Applicant: HUAWEI TECHNOLOGIES CO., LTD., Shenzhen, Guangdong 518129 (CN)
(72) Inventor: LI, Ke, Shenzhen, 518129 (CN); DING, Yaxue, Shenzhen, 518129 (CN); FENG, Shenglu, Shenzhen, 518129 (CN); LU, Fenglong, Shenzhen, 518129 (CN); TANG, Yunyu, Shenzhen, 518129 (CN); ZHANG, Pengcheng, Shenzhen, 518129 (CN); ZHENG, Shengnan, Shenzhen, 518129 (CN)
(74) Representative: Epping - Hermann - Fischer

(57) **Abstract**

This application provides a power converter and a relay heat dissipation apparatus. The power converter includes a circuit board, a DC/AC circuit, and a relay. The DC/AC circuit and the relay are mounted on the circuit board. The DC/AC circuit is configured to convert a direct current from a photovoltaic module or an energy storage battery into an alternating current. An alternating current end of the DC/AC circuit is electrically connected to the relay. The relay is configured to perform on-grid and off-grid switching of the power converter, the relay includes a relay housing, a fixed contact, and a pin, the fixed contact is located in the relay housing, one end of the pin is connected to the fixed contact, and the other end of the pin is fastened and electrically connected to the circuit board. The power converter further includes a heat conductor and a heat sink. The heat conductor and the relay are located on a same side or opposite sides of the circuit board. The heat conductor is separately in contact with the pin and the heat sink, to conduct heat on the pin to the heat sink and dissipate the heat. Heat dissipation efficiency of the relay is enhanced, so that stable and long-term running of the power converter is ensured while increasing a power level of the power converter.

## Description

### TECHNICAL FIELD

This application relates to the field of power electronics, and specifically, to a power converter and a relay heat dissipation apparatus.

### BACKGROUND

A power converter is a core device of a new energy power generation system, and is configured to: convert a direct current from a photovoltaic module or an energy storage battery into an alternating current, and transmit the alternating current to a power grid or a load. The power converter includes a relay. On-grid and off-grid switching of the power converter can be implemented by controlling on and off of the relay. Currently, as a power level of the power converter gradually increases, how to further improve a heat dissipation capability of the relay becomes an urgent problem to be resolved in the industry.

The relay includes a fixed contact, a moving contact, an electromagnetic drive mechanism, and a pin. The electromagnetic drive mechanism is configured to control the moving contact to be in contact with or separated from the fixed contact, to implement on and off of the relay. The fixed contact is connected to one end of the pin. The power converter further includes a circuit board, and the other end of the pin is electrically connected to the circuit board, to implement a connection between the relay and an external circuit. When the moving contact is in contact with the fixed contact, a resistance of a contact part between the moving contact and the fixed contact is larger than that of another conductor of the relay, causing the contact part between the moving contact and the fixed contact to be a main heat source of the relay. Heat generated by the contact part between the moving contact and the fixed contact is first transferred to the pin, and then transferred to the circuit board. Due to poor heat dissipation efficiency of the circuit board, if the heat on the pin cannot be dissipated in time as the power level of the power converter increases, the circuit board ages, affecting a service life and running safety of the power converter.

### SUMMARY

This application provides a power converter and a relay heat dissipation apparatus. Heat dissipation efficiency of a relay in the power converter and relay heat dissipation apparatus is enhanced, so that stable and long-term running of the power converter and relay heat dissipation apparatus can be ensured while increasing power levels of the power converter and relay heat dissipation apparatus.

According to a first aspect, this application provides a power converter. The power converter includes a circuit board, a DC/AC circuit, and a relay. The DC/AC circuit and the relay are mounted on the circuit board. The DC/AC circuit is configured to convert a direct current from a photovoltaic module or an energy storage battery into an alternating current. An alternating current end of the DC/AC circuit is electrically connected to the relay. The relay is configured to perform on-grid and off-grid switching of the power converter. The relay includes a relay housing, a fixed contact, and a pin. The fixed contact is located in the relay housing, one end of the pin is connected to the fixed contact, and the other end of the pin is fastened and electrically connected to the circuit board. The power converter further includes a heat conductor and a heat sink. The heat conductor and the relay are located on a same side or opposite sides of the circuit board. The heat conductor is separately in contact with the pin and the heat sink, to conduct heat on the pin to the heat sink and dissipate the heat.

In the power converter provided in this embodiment of this application, the heat conductor can conduct the heat on the pin to the heat sink, and the heat sink dissipates the heat. In comparison with a power converter that is not provided with a thermally conductive structure and a heat dissipation structure, in embodiments of this application, the heat conductor and the heat sink that are separately disposed are used to implement thermally conductive and heat dissipation functions. This greatly increases a thermally conductive area and a heat dissipation area of the pin. In this way, when a power level of the power converter increases, that is, when there is much heat generated inside the relay, the heat on the pin can be dissipated in time. This slows down aging of the circuit board, thereby helping prolong a service life of the power converter and ensure running safety of the power converter.

In addition, in the power converter provided in this embodiment of this application, one end of the pin is buried in the relay housing and is connected to the fixed contact of the relay, the other end of the pin is exposed outside the relay housing and is fastened and electrically connected to the circuit board, and the pin is in contact with the heat conductor located outside the relay housing. Therefore, there is no need to dispose, on a plate other than the bottom plate on the relay housing, a through hole through which the heat conductor passes, so that processing difficulty is reduced.

In an implementation, a surface that is of the heat conductor and that faces the circuit board is bonded or soldered to the circuit board, to conduct heat on the circuit board to the heat sink and dissipate the heat.

The heat conductor is fastened to the circuit board in a bonding or soldering manner, so that there is no gap between the heat conductor and the circuit board. Therefore, the heat conductor can better conduct the heat on the circuit board more quickly to the heat sink and dissipate the heat, thereby improving heat dissipation effect of the circuit board and prolonging a service life of the circuit board.

In an implementation, the heat conductor is a metal layer on a surface of the circuit board. The metal layer on the surface of the circuit board is used as the heat conductor, so that circuit arrangement and an electrical connection between another component (for example, a high-power component) and the circuit board can be implemented by using the circuit board, and heat conduction can be performed on a pin of the high-power component mounted on the circuit board, thereby simplifying a manufacturing process.

In an implementation, the heat conductor includes a first part and a second part that are connected, the first part is attached to the circuit board, and the second part extends toward a side away from the circuit board and is attached to the pin.

The first part of the heat conductor is located between the second part of the heat conductor and the circuit board, so that large space is reserved between the first part of the heat conductor and the top plate or the bottom plate of the housing. This facilitates arrangement of other components in the power converter, thereby improving space utilization of the power converter.

In an implementation, the heat conductor includes a fastening cradle. The fastening cradle extends toward a side facing the circuit board, and the fastening cradle is configured to be embedded into the circuit board. In this way, in a process of assembling the heat conductor with the circuit board, the fastening cradle on the heat conductor can be used to implement positioning and pre-fastening of the heat conductor.

In an implementation, when the heat conductor is located between the relay housing and the circuit board, there is a spacing between the heat conductor and the relay housing in an arrangement direction of the relay and the circuit board. In this way, the spacing between the heat conductor and the relay housing can constitute heat dissipation space, and the heat on the pin of the relay or the heat conducted by the heat conductor can be dissipated through the heat dissipation space, so that heat dissipation effect of the pin is improved.

In an implementation, the relay further includes a support cradle. The support cradle is located on a side that is of the relay housing and that faces the circuit board, and the support cradle passes through the heat conductor and abuts against the circuit board. In this way, the heat conductor may further conduct heat to the relay housing via the support cradle, thereby improving heat dissipation effect of the pin.

In an implementation, when the heat conductor is located on a side that is of the circuit board and that is away from the relay, the other end of the pin passes through the circuit board and is in contact with the heat conductor.

Usually, the relay is disposed on a front surface of the circuit board, and solder is filled between the pin of the relay and the circuit board from a back surface of the circuit board, to implement an electrical connection between the pin of the relay and the circuit board. The heat conductor is disposed on the back surface of the circuit board, so that whether the pin of the relay is fully soldered to the circuit board can be easily detected from the front surface of the circuit board, thereby helping improve assembly efficiency of the relay.

In addition, this avoids interference between the heat conductor and the support cradle caused because the heat conductor is disposed on the front surface of the circuit board, thereby ensuring stable support of the support cradle for the relay, and improving reliability of an electrical connection between the relay and the circuit board.

In an implementation, the heat conductor is located inside the circuit board, and the heat conductor is a metal layer. The metal layer inside the circuit board is used as the heat conductor, so that circuit arrangement and an electrical connection between another component (for example, a high-power component) and the circuit board can be implemented by using the circuit board, and heat conduction can be performed on a pin of the high-power component mounted on the circuit board, thereby simplifying a manufacturing process.

In an implementation, the heat sink includes a heat dissipation substrate and a plurality of heat sink fins. The heat dissipation substrate and the relay are spaced apart, and the plurality of heat sink fins are fastened to a surface that is of the heat dissipation substrate and that is away from the relay. The heat dissipation substrate is in contact with the heat conductor, to dissipate, via the plurality of heat sink fins, the heat conducted by the heat conductor from the pin. The plurality of heat sink fins in the heat sink are disposed on the surface that is of the heat dissipation substrate and that is away from the relay, so that the heat dissipated by the heat sink fins can be prevented, as much as possible, from directly diffusing toward the relay, and backflow of the heat dissipated by the heat sink fins to the relay can be reduced. This ensures effective heat conduction of the heat conductor and heat dissipation of the heat sink.

In an implementation, the plurality of heat sink fins are arranged in a direction perpendicular to the circuit board, and the heat sink fins extend in a direction perpendicular to the heat dissipation substrate. In this way, a spacing between two adjacent heat sink fins can be used as a channel through which a heat dissipation airflow flows. The heat dissipation airflow flowing through the channel does not diffuse toward the circuit board, thereby reducing backflow of the heat dissipated by the heat sink fins to the circuit board, and further improving heat dissipation effect of the heat sink.

In an implementation, the heat dissipation substrate includes a fastening end. The fastening end extends toward a side of the circuit board and passes through the heat conductor and the circuit board. Therefore, in a process of assembling the heat dissipation substrate with each of the heat conductor and the circuit board, the fastening end of the heat dissipation substrate can be used to implement positioning and pre-fastening of the heat dissipation substrate, so that the heat dissipation substrate is subsequently fastened to each of the heat conductor and the circuit board.

In an implementation, the fastening end includes a plurality of protrusions that are spaced apart. The plurality of protrusions extend toward the side of the circuit board and pass through the heat conductor and the circuit board. In this way, it is convenient for the heat dissipation substrate to be separately soldered to the heat conductor and the circuit board. In addition, the heat dissipation substrate can be more firmly connected to each of the heat conductor and the circuit board, so that a heat conduction path between the heat dissipation substrate and each of the heat conductor and the circuit board can be shortened, thereby improving heat dissipation effect.

In an implementation, the power converter includes a connecting piece. One end of the connecting piece is fastened to the relay housing, the other end of the connecting piece is clamped to or embedded into the heat dissipation substrate, and the connecting piece is disposed at a middle position and a position above the middle of the relay housing in a direction in which the relay housing is away from the circuit board; or one end of the connecting piece is fastened to the heat dissipation substrate, the other end of the connecting piece is clamped to or embedded into the relay housing, and the connecting piece is disposed at a middle position and a position above the middle of the heat dissipation substrate in a direction in which the heat dissipation substrate is away from the circuit board. This prevents the heat dissipation substrate from tilting, to ensure heat dissipation effect of the power converter.

In an implementation, the power converter further includes a fan, and an orientation of an air exhaust vent of the fan is perpendicular to an arrangement direction of the plurality of heat sink fins and an arrangement direction of the heat dissipation substrate and the relay. In this way, a spacing between two adjacent heat sink fins can be used as an air channel, and air blown out from the air exhaust vent of the fan flows through the air channel to take away heat on the heat sink fins, thereby improving heat dissipation efficiency of the heat sink.

In an implementation, the heat sink includes heat dissipation panel. The heat dissipation panel is located on a side that is of the heat conductor and that is away from the circuit board. The heat dissipation panel includes an internal flow channel, and the internal flow channel is used to transfer a cooling medium to dissipate the heat conducted by the heat conductor from the pin. In this way, the cooling medium in the internal flow channel of the heat dissipation panel can be in more sufficient contact with the inside of the heat dissipation panel, and a heat exchange area between the cooling medium and the heat dissipation panel is increased, thereby improving heat conduction efficiency. In addition, flowing of the cooling medium can also take away the heat on the heat dissipation panel, to accelerate a process of dissipating the heat on the heat dissipation panel, thereby improving heat dissipation effect of the heat dissipation panel.

In an implementation, the power converter further includes a thermally conductive connection layer, the thermally conductive connection layer is located between the heat conductor and the heat dissipation panel, hardness of the thermally conductive connection layer is less than hardness of the heat conductor and hardness of the heat dissipation panel, the other end of the pin passes through the heat conductor and is embedded into the thermally conductive connection layer, and the heat conductor is configured to conduct, to the heat dissipation panel via the thermally conductive connection layer, the heat conducted by the heat conductor from the pin. In this way, the heat conductor first conducts the heat generated on the pin to the thermally conductive connection layer, and then the thermally conductive connection layer conducts the heat on the pin and the heat conductor to the heat sink fins for dissipation, thereby improving heat conduction effect on the pin of the relay. In addition, through a soft connection of the thermally conductive connection layer, a zone with a large thermal resistance, for example, an air hole, between the heat conductor and the heat dissipation panel can be avoided as much as possible, thereby improving heat dissipation efficiency of the pin.

In an implementation, in an arrangement direction of the circuit board and the heat conductor, a projection of the heat conductor is located within a projection of the thermally conductive connection layer. In this way, a contact area between the thermally conductive connection layer and the heat conductor is increased, so that heat conduction effect of the thermally conductive connection layer for the pin and the heat conductor is improved.

In an implementation, the power converter further includes a solder layer. The solder layer is distributed between the pin and the heat conductor, and the heat conductor is fastened to the pin via the solder layer.

The heat conductor is fastened to the pin via the solder layer, so that the heat conductor can be closely attached to the pin, thereby reducing a probability of an electrochemical reaction between the heat conductor and the pin, and prolonging a service life of the power converter.

In an implementation, the power converter further includes a housing of the power converter. The housing of the power converter includes a top plate and a bottom plate, the top plate and the bottom plate are arranged opposite to each other in the arrangement direction of the circuit board and the relay, and the relay is located between the circuit board and the top plate. A spacing between the circuit board and the top plate is greater than a spacing between the circuit board and the bottom plate. In this way, space inside the housing of the power converter can be fully used, to provide large heat dissipation space for the relay or another component on the circuit board, thereby improving heat dissipation effect of the power converter.

According to a second aspect, a relay heat dissipation apparatus is provided. The relay heat dissipation apparatus includes a circuit board, a relay, a heat conductor, and a heat sink. The relay is mounted on the circuit board. The relay is configured to perform on-grid and off-grid switching of the power converter, the relay includes a relay housing, a fixed contact, and a pin, the fixed contact is located in the relay housing, one end of the pin is connected to the fixed contact, and the other end of the pin is fastened and electrically connected to the circuit board. The heat conductor and the relay are located on a same side or opposite sides of the circuit board. The heat conductor is separately in contact with the pin and the heat sink, to conduct heat on the pin to the heat sink and dissipate the heat.

For technical effect of the second aspect, refer to the descriptions of related technical effect of the first aspect. Details are not described herein again.

### BRIEF DESCRIPTION OF DRAWINGS

FIG. 1 is a diagram of a new energy power generation system;
FIG. 2 is a sectional diagram of a power converter according to an embodiment of this application;
FIG. 3 is a diagram of a power converter according to an embodiment of this application;
FIG. 4 is another diagram of a power converter according to an embodiment of this application;
FIG. 5 to FIG. 8 each are another diagram of a power converter according to an embodiment of this application;
FIG. 9 is a diagram in which a heat conductor is a metal layer disposed on a back surface of a circuit board;
FIG. 10 is a diagram in which a heat conductor is a metal layer disposed inside a circuit board;
FIG. 11 is a diagram of a heat conductor according to an embodiment of this application;
FIG. 12 is another diagram of a heat conductor according to an embodiment of this application;
FIG. 13 to FIG. 16 each are another diagram of a power converter according to an embodiment of this application;
FIG. 17 is another diagram of a power converter according to an embodiment of this application;
FIG. 18 is another diagram of a power converter according to an embodiment of this application;
FIG. 19 and FIG. 20 each are another diagram of a power converter according to an embodiment of this application;
FIG. 21 is another diagram of a power converter according to an embodiment of this application;
FIG. 22 is another diagram of a power converter according to an embodiment of this application;
FIG. 23 to FIG. 26 each are another diagram of a power converter according to an embodiment of this application;
FIG. 27 is a diagram of a tooth-shaped heat sink according to an embodiment of this application;
FIG. 28 is another diagram of a tooth-shaped heat sink according to an embodiment of this application;
FIG. 29 to FIG. 32 each are another diagram of a power converter according to an embodiment of this application;
FIG. 33 is another diagram of a power converter according to an embodiment of this application;
FIG. 34 to FIG. 36 each are another diagram of a power converter according to an embodiment of this application;
FIG. 37 is another diagram of a power converter according to an embodiment of this application; and
FIG. 38 is another diagram of a power converter according to an embodiment of this application.

### DESCRIPTION OF EMBODIMENTS

The following describes technical solutions of this application with reference to accompanying drawings.

In this application, "parallel" is not strictly parallel, but within an allowable error range. "Perpendicular" is not strictly perpendicular, but within an allowable error range.

In embodiments of this application, a same reference numeral indicates a same component part or a same part or component. In embodiments of this application, for a plurality of same parts or components, only one part or component may be marked with a reference numeral as an example in the accompanying drawings. For another same part or component, the reference numeral is also applicable. In addition, dimensions and sizes of parts or components shown in the accompanying drawings are merely examples.

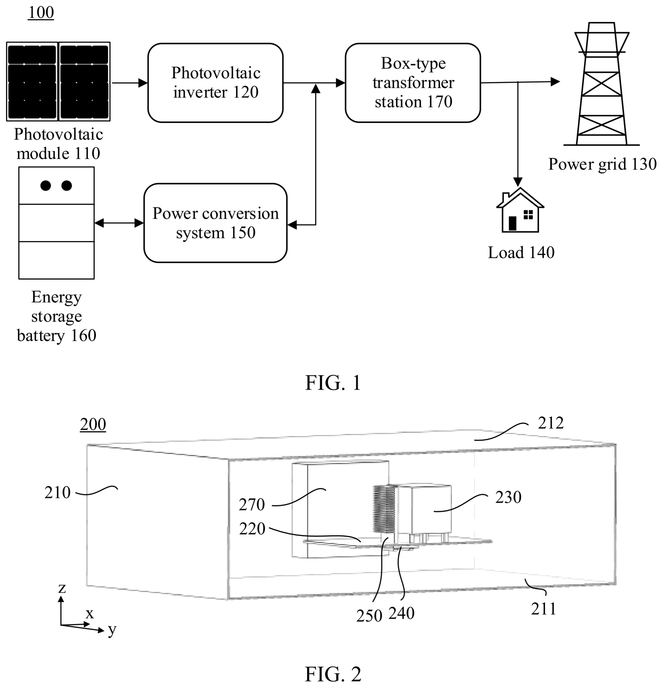

FIG. 1 is a diagram of a new energy power generation system. As shown in FIG. 1, the new energy power generation system 100 includes one or more photovoltaic modules 110, a photovoltaic inverter 120, a power grid 130, a load 140, a power conversion system 150, and an energy storage battery 160.

The photovoltaic inverter 120 is connected to the photovoltaic module 110, and is configured to: convert, into an alternating current, a direct current transmitted by the photovoltaic module 110, and transmit the alternating current to the power grid 130 or the load 140.

In an embodiment, the new energy power generation system 100 further includes a box-type transformer station 170. The box-type transformer station 170 is configured to: boost the alternating current converted by the photovoltaic inverter 120, and transmit a boosted alternating current to the power grid 130 via a booster station.

The power conversion system 150 is connected to the energy storage battery 160, and is configured to: convert, into an alternating current, a direct current transmitted by the energy storage battery 160, and transmit the alternating current to the power grid 130 or the load 140. The power conversion system 150 is further configured to: after receiving an alternating current from the power grid 130 or the load 140 and converting the alternating current into a direct current, transmit the direct current to the energy storage battery 160 for storage. For example, the energy storage battery 160 may be a storage battery, or may be an energy storage container, or may be an apparatus used for energy storage in another form.

In an embodiment, the box-type transformer station 170 is further configured to: boost the alternating current converted by the power conversion system 150, and transmit a boosted alternating current to the power grid 130 via a booster station.

In an embodiment, the box-type transformer station 170 is further configured to: step down the alternating current from the power grid 130, and transmit a stepped-down alternating current to the power conversion system 150.

The photovoltaic inverter 120 or the power conversion system 150 shown in FIG. 1 may be collectively referred to as a power converter.

As described in the background, if the heat on the pin of the relay in the power converter cannot be dissipated in time as the power level of the power converter increases, the circuit board in the power converter ages, affecting a service life and running safety of the power converter.

In view of this, embodiments of this application provide a power converter 200. The power converter 200 may be the photovoltaic inverter 120 or the power conversion system 150 shown in FIG. 1.

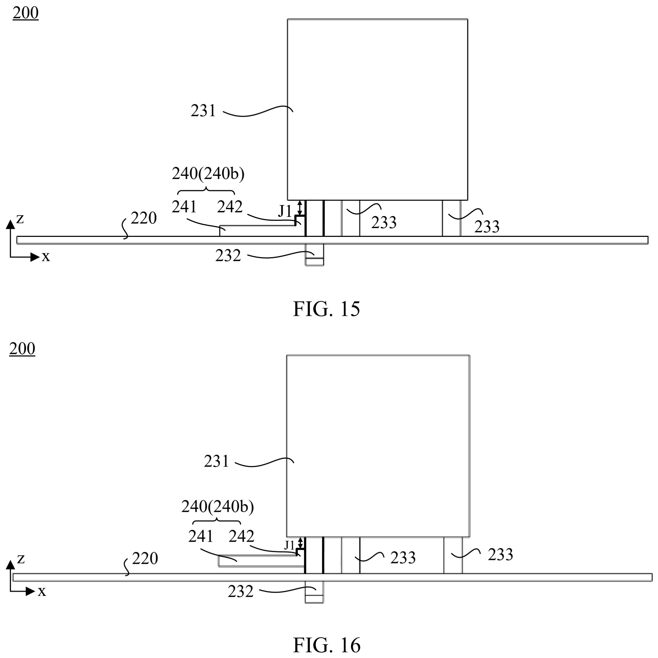

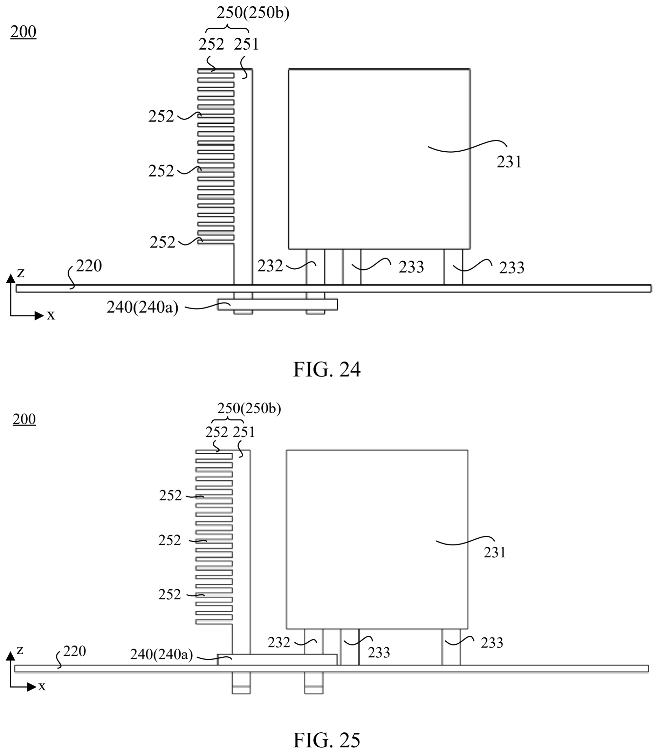

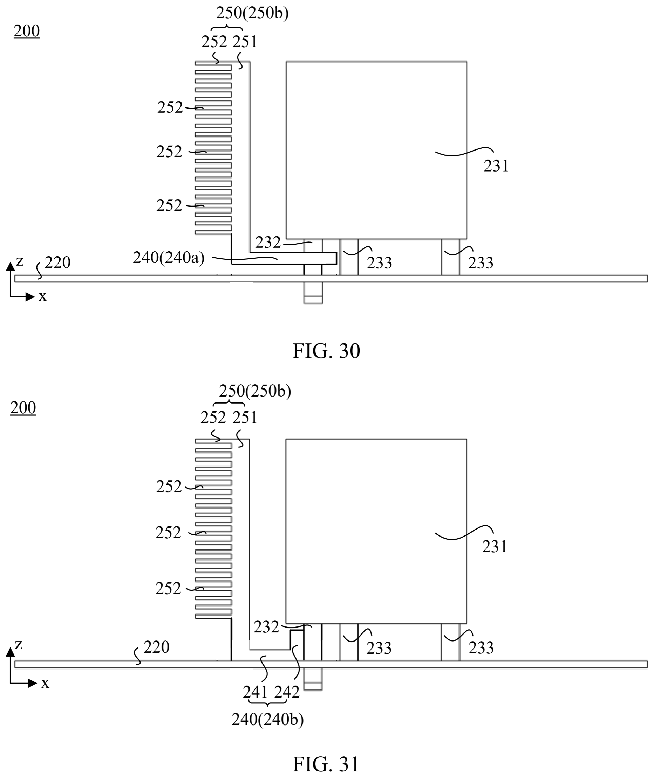

The following describes in detail a specific structure of the power converter provided in embodiments of this application with reference to FIG. 2 to FIG. 33.

FIG. 2 is a sectional diagram of a power converter according to an embodiment of this application. As shown in FIG. 2, the power converter 200 includes a housing 210, the housing 210 has an accommodation cavity, and the accommodation cavity is configured to accommodate components of the power converter 200.

In an embodiment, as shown in FIG. 2, a length direction of the housing 210 is an x direction, a width direction of the housing 210 is a y direction, a height direction of the housing 210 is a z direction, and the x direction, the y direction, and the z direction are perpendicular to each other.

The power converter 200 further includes a circuit board 220, a direct current/alternating current (DC/AC) circuit, and a high through-current component. The DC/AC circuit, the circuit board 220, and the high through-current component are accommodated in the housing 210. The DC/AC circuit and the high through-current component are mounted on the circuit board 220. As shown in FIG. 2, the housing 210 includes a bottom plate 211 and a top plate 212, and the bottom plate 211 and the top plate 212 are arranged opposite to each other in the z direction. In the z direction, the circuit board 220 and the high through-current component are distributed between the bottom plate 211 and the top plate 212 of the housing 210. The DC/AC circuit is configured to convert a direct current from a photovoltaic module or an energy storage battery into an alternating current. An alternating current end of the DC/AC circuit is electrically connected to the high through-current component.

In an embodiment, a spacing between the circuit board 220 and the top plate 212 of the housing 210 is greater than a spacing between the circuit board 220 and the bottom plate 211 of the housing 210.

Usually, a surface that is of the circuit board 220 and that faces the top plate 212 of the housing 210 is used to mount the high through-current component or another component of the power converter 200. The spacing between the circuit board 220 and the top plate 212 of the housing 210 is set to be larger than the spacing between the circuit board 220 and the bottom plate 211 of the housing 210, so that internal space of the housing 210 of the power converter 200 can be fully used, to provide large heat dissipation space for the high through-current component or the another component on the circuit board 220, thereby improving heat dissipation effect of the power converter 200.

In embodiments of this application, the circuit board 220 may also be referred to as a printed circuit board assembly (PCBA).

In embodiments of this application, the high through-current component is a component that can bear a high current in a working process. For example, the high through-current component includes a relay 230, a power inductor, a switch transistor of a DC/DC circuit or the DC/AC circuit, or the like. The relay 230 is configured to perform on-grid and off-grid switching of the power converter 200. The DC/DC circuit is configured to perform voltage conversion on a direct current from the photovoltaic module 110 or the energy storage battery 160. The DC/AC circuit is configured to: convert, into an alternating current, the direct current obtained through voltage conversion by the DC/DC circuit, and transmit the alternating current to a power grid or a load via an alternating current output end of the power converter 200. The relay 230 is electrically connected between the DC/AC circuit and the alternating current output end of the power converter 200, and is configured to perform on-grid and off-grid switching of the power converter 200.

It should be noted that any circuit that can implement a function of converting the direct current to the alternating current may be referred to as the DC/AC circuit, and whether the circuit can implement another function is not limited in this application.

For ease of description, the following uses an example in which the high through-current component is the relay 230 for description.

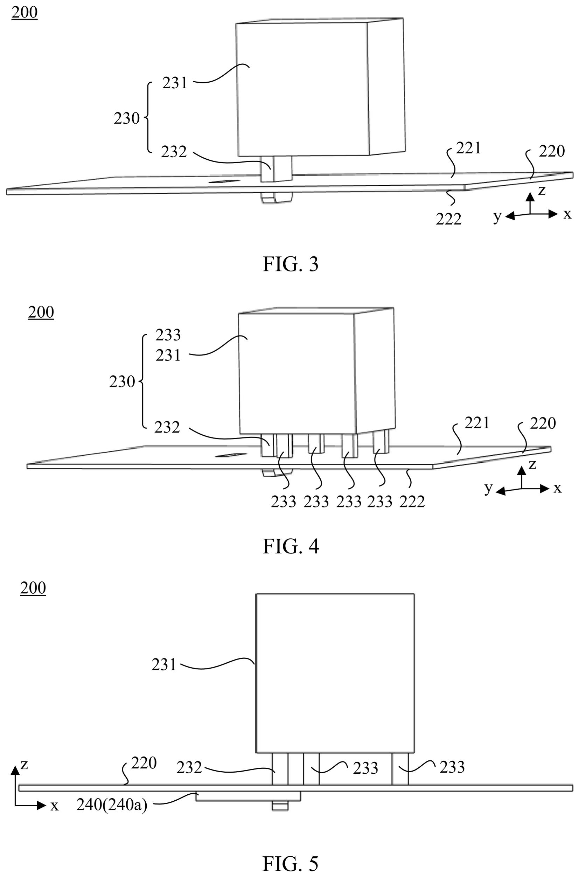

FIG. 3 is a diagram of a power converter according to an embodiment of this application. As shown in FIG. 3, the circuit board 220 includes a surface 221 and a surface 222 that are arranged opposite to each other in the z direction. The relay 230 is mounted on the surface 221 of the circuit board 220. In other words, the relay 230 is distributed on a side that is of the circuit board 220 and that faces the top plate 212 of the housing 210. The surface 221 of the circuit board 220 is a front surface of the circuit board 220, and the surface 222 of the circuit board 220 is a back surface of the circuit board 220.

The relay 230 includes a fixed contact, a moving contact, and an electromagnetic drive mechanism. The electromagnetic drive mechanism is configured to control the moving contact to be in contact with or separated from the fixed contact, to implement on and off of the relay 230.

As shown in FIG. 3, the relay 230 further includes a relay housing 231 and a pin 232. One end of the pin 232 extends into the relay housing 231, and the other end of the pin 232 is exposed outside the relay housing 231. The one end of the pin 232 is connected to the fixed contact, and heat generated by a contact part between the moving contact and the fixed contact is transferred to the pin via the fixed contact. The other end of the pin 232 is fastened and electrically connected to the circuit board 220. In this way, each pin 232 may be considered as a through-current path of the relay 230.

The pin 232 of the relay 230 is mounted on the circuit board 220 from a front side of the circuit board 220, and solder is filled between the circuit board 220 and the other end of the pin 232 of the relay 230 from a rear side of the circuit board 220, so that the other end of the pin 232 is electrically connected to the circuit board 220, and the relay 230 and the circuit board 220 are fastened.

In an embodiment, there are a plurality of pins 232 of the relay 230. In this way, a through-current path of the relay 230 can be increased, so that a current carried on each pin 232 can be reduced, and stability of the relay 230 can be improved.

In an example, the plurality of pins 232 of the relay 230 are distributed in a plurality of rows. For example, the plurality of pins 232 of the relay 230 are arranged in the plurality of rows in an x direction, and pins 232 in each row are arranged in a y direction. In this way, there are a plurality of contact points between the circuit board 220 and the plurality of pins 232 distributed in the plurality of rows in the x direction and the y direction respectively, so that a force in the x direction and a force in the y direction can be better resisted, thereby reducing a risk of skew or deformation of the relay 230, and ensuring stability of the relay 230.

It should be understood that an example in which there is one pin 232 is used for illustration in FIG. 2 to FIG. 26, FIG. 28 to FIG. 32, and shall not constitute a limitation on this application.

FIG. 4 is another diagram of a power converter according to an embodiment of this application. In an embodiment, the relay 230 further includes a support cradle 233. The support cradle 233 is located on a side that is of the relay housing 231 and that faces the circuit board 220. The support cradle 233 separately abuts against the circuit board 220 and the relay housing 231, to support the relay housing 231 and a component inside the relay housing 231.

In an embodiment, there are a plurality of support cradles 233, so that the plurality of support cradles 233 can stably support the relay 230, thereby improving stability of the relay 230, and helping improve reliability of an electrical connection between the relay 230 and the circuit board 220.

FIG. 5 to FIG. 8 each are another diagram of a power converter according to an embodiment of this application. As shown in FIG. 5 to FIG. 8, the power converter 200 further includes a heat conductor 240. As shown in FIG. 2, the heat conductor 240 is accommodated in the housing 210. The heat conductor 240 is in contact with the pin 232 to conduct heat to the pin 232.

An arrangement direction of the heat conductor 240 and the circuit board 220 is parallel to an arrangement direction of the relay 230 and the circuit board 220. In other words, the arrangement direction of the heat conductor 240 and the circuit board 220 is parallel to the z direction.

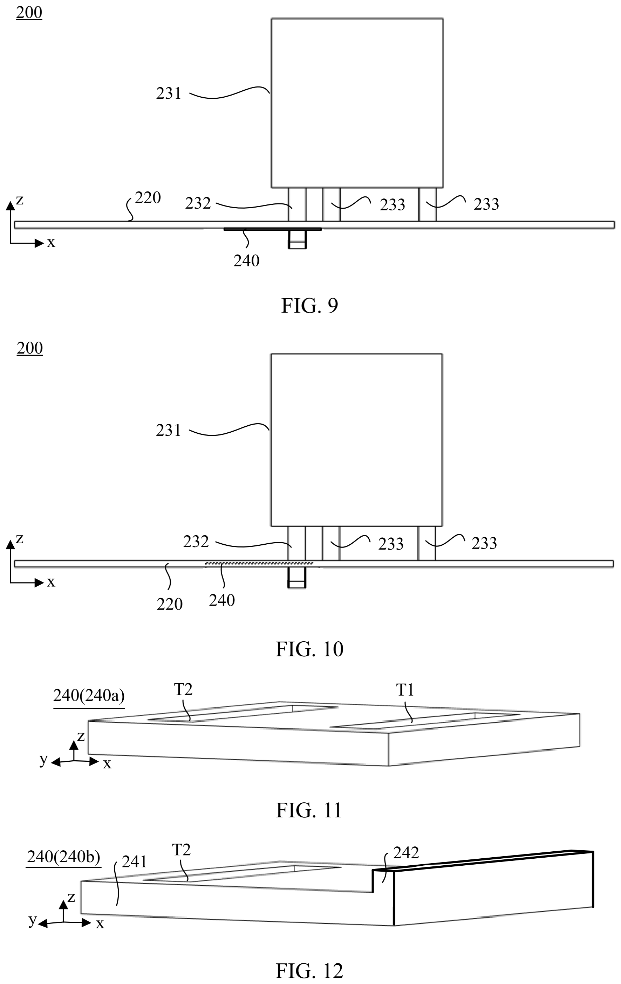

In an embodiment, the heat conductor 240 is a metal layer on a surface of or inside the circuit board 220. During actual application, a thickness of the metal layer is usually very thin. For example, the thickness is less than or equal to 1 mm. In this way, a circuit can be arranged by using the circuit board 220, and heat conduction can be performed on a pin of a high-power component mounted on the circuit board 220, thereby simplifying a manufacturing process. Correspondingly, FIG. 9 and FIG. 10 are respectively diagrams in which the heat conductor 240 is a metal layer disposed on a back surface and inside the circuit board 220. The heat conductor 240 shown in FIG. 9 is moved from below the circuit board 220 to above the circuit board 220, so that a diagram in which the heat conductor 240 is a metal layer disposed on a front surface of the circuit board 220 can be obtained. No corresponding diagram is provided in the accompanying drawings.

In an embodiment, a surface that is of the heat conductor 240 and that faces the circuit board 220 is bonded to the circuit board 220, to conduct heat on the circuit board 220. The heat conductor 240 is fastened to the circuit board 220 in a bonding manner, so that there is no gap between the heat conductor 240 and the circuit board 220. Therefore, the heat conductor 240 can better conduct the heat on the circuit board 220 more quickly, thereby improving heat dissipation effect of the circuit board 220 and prolonging a service life of the circuit board 220.

For example, a thermally conductive medium layer is disposed between the heat conductor 240 and the circuit board 220. In this way, the heat conductor 240 is bonded to the circuit board 220 via the thermally conductive medium layer, so that an air gap between the heat conductor 240 and the circuit board 220 can be reduced, and a thermal resistance between the heat conductor 240 and the circuit board 220 can be reduced. This improves heat dissipation efficiency. A material of the thermally conductive medium layer includes silicone.

In an embodiment, a surface that is of the heat conductor 240 and that faces the circuit board 220 is soldered to the circuit board 220, to conduct heat on the circuit board 220. The heat conductor 240 is fastened to the circuit board 220 through soldering, so that there is no gap between the heat conductor 240 and the circuit board 220. Therefore, the heat conductor 240 can better conduct the heat on the circuit board 220 more quickly, thereby improving heat dissipation effect of the circuit board 220 and prolonging a service life of the circuit board 220.

For example, a soldering layer is filled between the heat conductor 240 and the circuit board 220. In this way, the heat conductor 240 is bonded to the circuit board 220 via the soldering layer.

In an embodiment, the heat conductor 240 includes a fastening cradle. The fastening cradle extends toward a side facing the circuit board 220, and the fastening cradle is configured to be embedded into the circuit board 220. In this way, in a process of assembling the heat conductor 240 with the circuit board 220, the fastening cradle on the heat conductor 240 can be used to implement positioning and pre-fastening of the heat conductor 240.

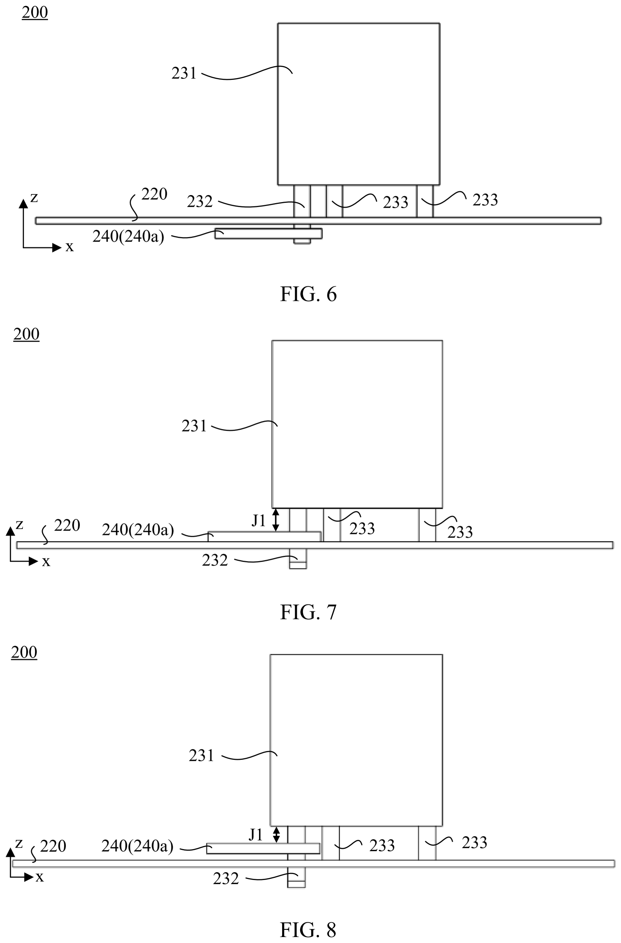

In an embodiment, the heat conductor 240 and the relay 230 are located on two opposite sides of the circuit board 220. In other words, as shown in FIG. 5 and FIG. 6, the heat conductor 240 is located on a side that is of the circuit board 220 and that is away from the relay 230, and the pin 232 passes through the circuit board 220 and is in contact with the heat conductor 240.

Solder is filled between the pin 232 of the relay 230 and the circuit board 220 from the back surface of the circuit board 220. Therefore, the heat conductor 240 is disposed on the back surface of the circuit board 220, so that whether the pin 232 of the relay 230 is fully soldered to the circuit board 220 can be easily detected from the front surface of the circuit board 220, thereby helping improve assembly efficiency of the relay 230.

In addition, this avoids interference between the heat conductor 240 and the support cradle 233 caused because the heat conductor 240 is disposed on the front surface of the circuit board 220, thereby ensuring stable support of the support cradle 233 for the relay 230, and improving reliability of an electrical connection between the relay 230 and the circuit board 220.

In an embodiment, the heat conductor 240 and the relay 230 are located on a same side of the circuit board 220. For example, both the heat conductor 240 and the relay 230 are located on a front side of the circuit board 220.

In an embodiment, as shown in FIG. 7 and FIG. 8, the heat conductor 240 is located between the relay housing 231 and the circuit board 220, and the pin 232 passes through the heat conductor 240 and is electrically connected to the circuit board 220. In other words, heat on the pin 232 is first transferred to the heat conductor 240, and then transferred to the circuit board 220. In this way, before the heat on the pin 232 is transferred to the circuit board 220, the heat conductor 240 can conduct and dissipate a part of the heat on the pin 232 via the heat conductor 240. This reduces the heat transferred from the pin 232 to the circuit board 220, thereby slowing down an aging rate of the circuit board 220. In an embodiment, as shown in FIG. 7 and FIG. 8, there is a spacing J1 between the heat conductor 240 and the relay housing 231 in an arrangement direction of the relay 230 and the circuit board 220. In this way, the spacing J1 between the heat conductor 240 and the relay housing 231 can constitute heat dissipation space, and the heat on the pin 232 of the relay 230 or the heat conducted by the heat conductor 240 can be dissipated through the heat dissipation space, so that heat dissipation effect of the pin 232 is improved.

In an embodiment, the support cradle 233 passes through the heat conductor 240 and abuts against the circuit board 220. In this way, the heat conductor 240 may further conduct heat to the relay housing 231 via the support cradle 233, thereby improving heat dissipation effect of the pin 232.

FIG. 11 is a diagram of a heat conductor according to an embodiment of this application. In an embodiment, as shown in FIG. 11, the heat conductor 240 is of a flat plate structure 240a. Therefore, the heat conductor 240 has the simple structure and low production difficulty.

In an embodiment, as shown in FIG. 11, the heat conductor 240 includes a through hole T1, and the pin 232 passes through the through hole T1 of the heat conductor 240. In this way, reliability of heat conduction between the pin 232 and the heat conductor 240 is improved.

FIG. 12 is another diagram of a heat conductor according to an embodiment of this application. In an embodiment, as shown in FIG. 12, the heat conductor 240 is of a folded plate structure 240b. As shown in FIG. 12, the heat conductor 240 includes a first part 241 and a second part 242. The first part 241 is attached to the circuit board 220, and the second part 242 is attached to the pin 232. In this way, the heat conductor 240 can be attached to both the circuit board 220 and the pin 232 via the folded plate structure 240b.

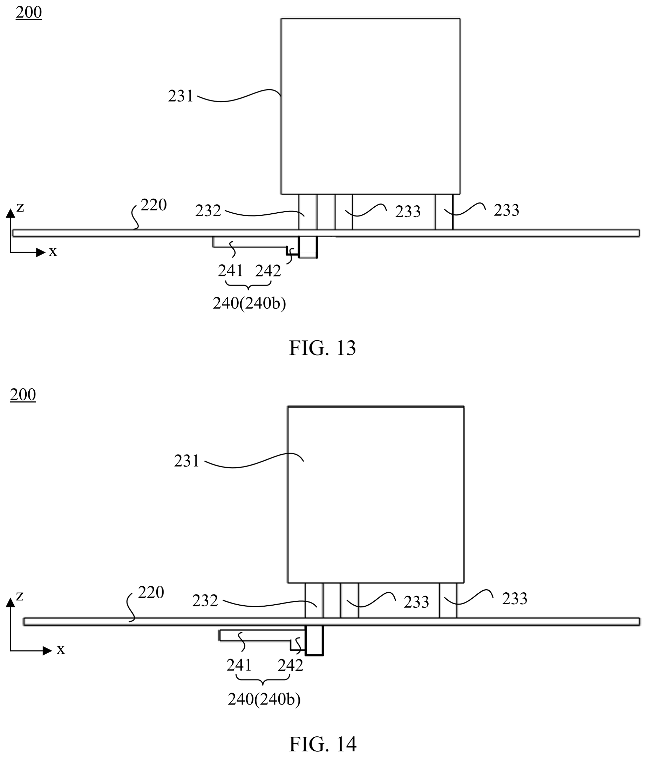

FIG. 13 to FIG. 16 each are another diagram of a power converter according to an embodiment of this application. In an embodiment, as shown in FIG. 13 to FIG. 16, the second part 242 of the heat conductor 240 is distributed on a side that is of the first part 241 of the heat conductor 240 and that is away from the circuit board 220. In other words, the second part 242 extends toward a side away from the circuit board 220.

The first part 241 of the heat conductor 240 is located between the second part 242 of the heat conductor 240 and the circuit board 220, so that large space is reserved between the first part 241 of the heat conductor 240 and the top plate 212 or the bottom plate 211 of the housing 210. This facilitates arrangement of other components in the power converter 200, thereby improving space utilization of the power converter 200.

In an embodiment, there are two heat conductors 240. The two heat conductors 240 are distributed on two sides of the circuit board 220 in an arrangement direction of the relay 230 and the circuit board 220. To be specific, one heat conductor 240 is located on a side that is of the circuit board 220 and that is away from the relay 230, and the other heat conductor 240 is located between the relay housing 231 and the circuit board 220. The two heat conductors 240 are both in contact with the other end of the pin 232 and conduct heat to the pin 232, so that heat conduction efficiency of the heat conductor 240 for the pin 232 is improved.

In an embodiment, the two heat conductors 240 have a same structure. Therefore, the heat conductors 240 can be produced in a standardized manner, and production efficiency of the heat conductors 240 is improved.

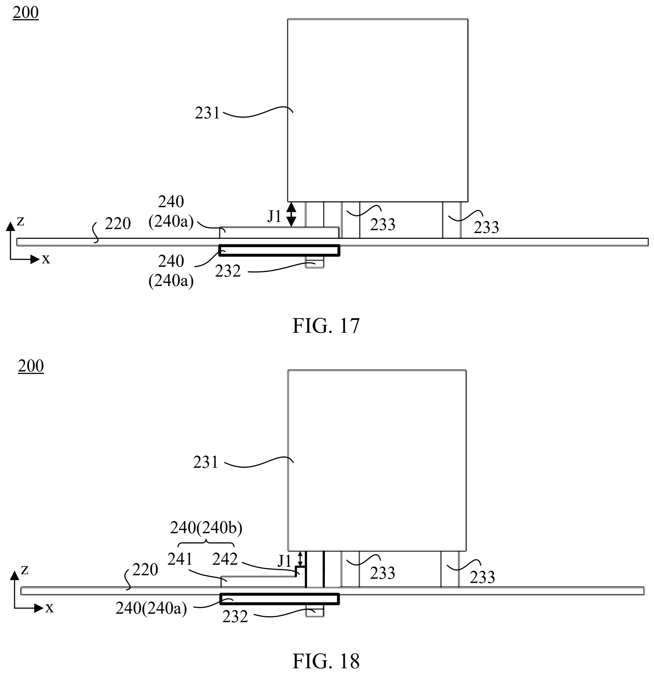

FIG. 17 is another diagram of a power converter according to an embodiment of this application. As shown in FIG. 17, structures of the two heat conductors 240 are both the heat conductor 240a shown in FIG. 11.

In an embodiment, the two heat conductors 240 have different structures. Therefore, the structures of the heat conductors 240 can be flexibly used based on a layout of the components in the power converter 200, to improve space utilization of the power converter 200.

FIG. 18 is another diagram of a power converter according to an embodiment of this application. For example, as shown in FIG. 18, a structure of one heat conductor 240 in the two heat conductors 240 is the flat plate structure 240a shown in FIG. 11, and a structure of the other heat conductor is the folded plate structure 240b shown in FIG. 12.

In an embodiment, as shown in FIG. 5, FIG. 7, FIG. 13, or FIG. 15, the heat conductor 240 is in contact with the circuit board 220. In this way, the heat conductor 240 can conduct the heat to both the pin 232 of the relay 230 and the circuit board 220, thereby improving heat dissipation effect of the circuit board 220 and prolonging a service life of the circuit board 220.

In an embodiment, as shown in FIG. 6, FIG. 8, FIG. 14, or FIG. 16, there is a spacing between the heat conductor 240 and the circuit board 220. In this way, a contact area between the heat conductor 240 and air can be increased, thereby improving heat conduction effect of the heat conductor 240.

In an embodiment, the power converter 200 further includes a solder layer 243. The solder layer 243 is distributed between the pin 232 and the heat conductor 240, and the heat conductor 240 is fastened to the pin 232 via the solder layer 243.

The heat conductor 240 is fastened to the pin 232 via the solder layer 243, so that the heat conductor 240 can be closely attached to the pin 232, thereby reducing a probability of an electrochemical reaction between the heat conductor 240 and the pin 232, and prolonging a service life of the power converter 200.

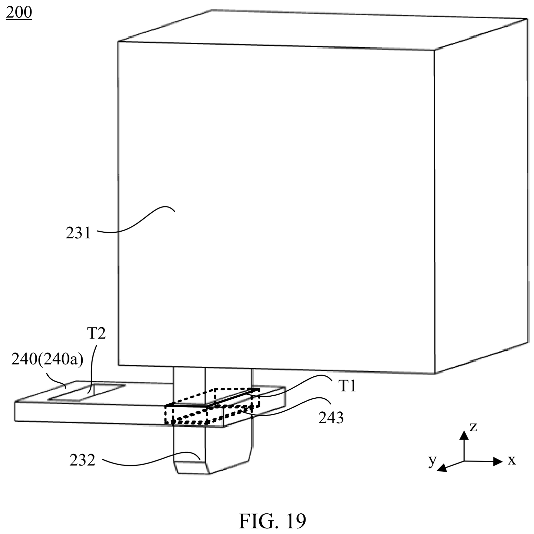

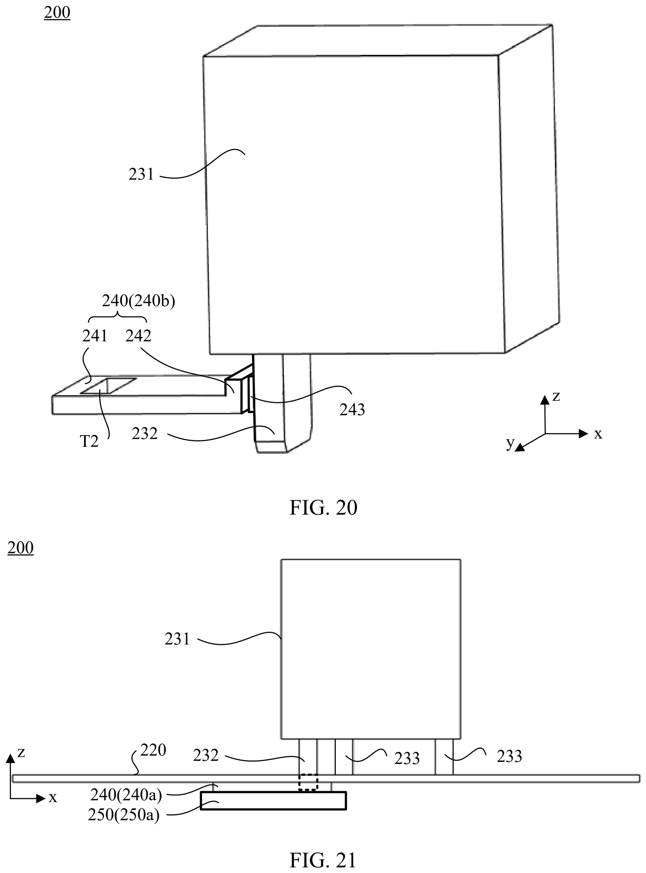

FIG. 19 and FIG. 20 each are another diagram of a power converter according to an embodiment of this application. In an embodiment, as shown in FIG. 19, the solder layer 243 is distributed between the pin 232 and a hole wall of the through hole T1 of the heat conductor 240a. In an embodiment, as shown in FIG. 20, the solder layer 243 is distributed between the pin 232 and the second part 242 of the heat conductor 240b.

The power converter 200 further includes a heat sink 250. As shown in FIG. 2, the heat sink 250 is accommodated in the housing 210. The heat conductor 240 is in contact with the heat sink 250, to conduct the heat on the pin 232 to the heat sink 250 and dissipate the heat.

In the power converter 200 provided in this embodiment of this application, the heat conductor 240 can conduct the heat on the pin 232 to the heat sink 250, and the heat sink 250 dissipates the heat. In comparison with a power converter that is not provided with a thermally conductive structure and a heat dissipation structure, in embodiments of this application, the heat conductor 240 and the heat sink 250 that are separately disposed are used to implement thermally conductive and heat dissipation functions. This greatly increases a thermally conductive area and a heat dissipation area of the pin 232. In this way, when a power level of the power converter 200 increases, that is, when there is much heat generated inside the relay 230, the heat on the pin 232 can be dissipated in time. This slows down aging of the circuit board 220, thereby helping prolong a service life of the power converter 200 and ensure running safety of the power converter 200.

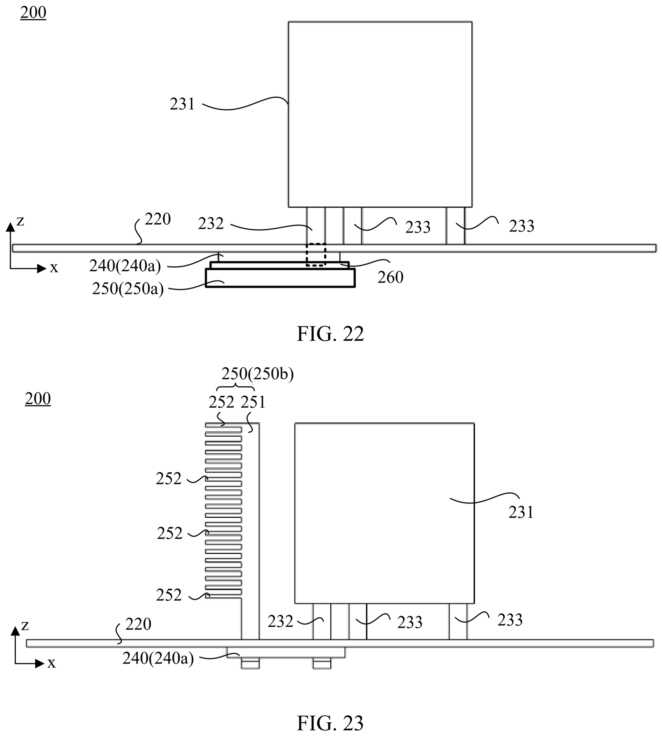

In addition, in the power converter 200 provided in this embodiment of this application, one end of the pin 232 is buried in the relay housing 231, the other end of the pin 232 is exposed outside the relay housing 231 and is fastened and electrically connected to the circuit board 220, and the pin 232 is in contact with the heat conductor 240 located outside the relay housing 231. Therefore, there is no need to dispose, on a plate other than the bottom plate on the relay housing 231, a through hole through which the heat conductor 240 passes, so that processing difficulty is reduced. FIG. 21 is another diagram of a power converter according to an embodiment of this application. In an embodiment, as shown in FIG. 21 and FIG. 22, the heat sink 250 includes a heat dissipation panel 250a, and the heat dissipation panel 250a is located on a side that is of the heat conductor 240 and that is away from the circuit board 220. The heat dissipation panel 250a is in contact with the heat conductor 240, and the pin 232 is embedded into the heat conductor 240.

In an embodiment, the heat dissipation panel 250a includes an internal flow channel, and the internal flow channel is used to transfer a cooling medium to dissipate the heat conducted by the heat conductor 240 from the pin 232. In this way, the cooling medium in the internal flow channel of the heat dissipation panel 250a can be in more sufficient contact with the inside of the heat dissipation panel 250a, and a heat exchange area between the cooling medium and the heat dissipation panel 250a is increased, thereby improving heat conduction efficiency. In addition, flowing of the cooling medium can also take away the heat on the heat dissipation panel 250a, to accelerate a process of dissipating the heat on the heat dissipation panel 250a, thereby improving heat dissipation effect of the heat dissipation panel 250a.

FIG. 22 is another diagram of a power converter according to an embodiment of this application. In an embodiment, as shown in FIG. 22, the power converter 200 further includes a thermally conductive connection layer 260. The thermally conductive connection layer 260 is located between the heat conductor 240 and the heat dissipation panel 250a. The other end of the pin 232 passes through the heat conductor 240 and is embedded into the thermally conductive connection layer 260. The heat conductor 240 is configured to conduct, to the heat dissipation panel 250a via the thermally conductive connection layer 260, the heat conducted from the heat conductor 240 from the pin 232. That is, the heat conductor 240 first conducts the heat generated on the pin 232 to the thermally conductive connection layer 260, and then the thermally conductive connection layer 260 conducts the heat on the pin 232 and the heat conductor 240 to the heat sink fins 252 for dissipation.

In an embodiment, hardness of the thermally conductive connection layer 260 is less than hardness of the heat conductor 240 and hardness of the heat dissipation panel 250a. In other words, compared with the heat conductor 240, the thermally conductive connection layer 260 is more prone to deformation. If a plane that is of the heat conductor 240 or the heat dissipation panel 250a and that faces the thermally conductive connection layer 260 is uneven, the thermally conductive connection layer 260 can be in sufficient contact with the plane that is of the heat conductor 240 or the heat dissipation panel 250a and that faces the thermally conductive connection layer 260 through a soft connection of the thermally conductive connection layer 260, to avoid, as much as possible, a zone with a large thermal resistance, for example, an air hole, between the heat conductor 240 and the heat dissipation panel 250a, thereby improving heat dissipation efficiency of the pin 232.

In an embodiment, the thermally conductive connection layer 260 may also be referred to as a thermally conductive adhesive connection layer 260. In other words, thermally conductive adhesive constitutes the thermally conductive connection layer 260.

In an embodiment, in an arrangement direction of the circuit board 220 and the heat conductor 240, a projection of the heat conductor 240 is located within a projection of the thermally conductive connection layer 260. In this way, a contact area between the thermally conductive connection layer 260 and the heat conductor 240 is increased, so that heat conduction effect of the thermally conductive connection layer 260 for the pin 232 and the heat conductor 240 is improved.

FIG. 23 to FIG. 26 each are another diagram of a power converter according to an embodiment of this application. In an embodiment, as shown in FIG. 23 to FIG. 26, the heat sink 250 includes a tooth-shaped heat sink 250b. Specifically, the tooth-shaped heat sink 250b includes a heat dissipation substrate 251 and a plurality of heat sink fins 252. The heat dissipation substrate 251 and the relay 230 are spaced apart, and the plurality of heat sink fins 252 are fastened to the heat dissipation substrate 251. The heat dissipation substrate 251 is in contact with the heat conductor 240, to dissipate, via the plurality of heat sink fins 252, the heat conducted by the heat conductor 240 from the pin 232.

In an embodiment, as shown in FIG. 23 to FIG. 26, the plurality of heat sink fins 252 are fastened to a surface that is of the heat dissipation substrate 251 and that is away from the relay 230. In this case, the heat dissipated by the heat sink fins 252 can be prevented, as much as possible, from directly diffusing toward the relay 230, and backflow of the heat dissipated by the heat sink fins 252 to the relay 230 can be reduced. This ensures effective heat conduction of the heat conductor 240 and heat dissipation of the heat sink 250.

In an embodiment, the plurality of heat sink fins 252 are arranged in a direction perpendicular to the circuit board 220. The direction perpendicular to the circuit board 220 may be understood as a direction perpendicular to a surface with a largest area in all surfaces of the circuit board 220. As shown in FIG. 23 to FIG. 26, the plurality of heat sink fins 252 are arranged in the z direction. In addition, the heat sink fins 252 extend in a direction perpendicular to the heat dissipation substrate 251. The direction perpendicular to the heat dissipation substrate 251 may be understood as a direction perpendicular to a surface with a largest area in all surfaces of the heat dissipation substrate 251. As shown in FIG. 23 to FIG. 26, the heat sink fins 252 are arranged in the x direction. In this way, a spacing between two adjacent heat sink fins 252 can be used as a channel through which a heat dissipation airflow flows. The heat dissipation airflow flowing through the channel does not diffuse toward the circuit board 220, thereby reducing backflow of the heat dissipated by the heat sink fins 252 to the circuit board 220, and further improving heat dissipation effect of the heat sink 250.

In an embodiment, as shown in FIG. 23 to FIG. 26, the heat dissipation substrate 251 passes through the heat conductor 240. For example, as shown in FIG. 11 or FIG. 12, the heat conductor 240 includes a through hole T2, and the heat dissipation substrate 251 passes through the heat conductor 240 via the through hole T2 of the heat conductor 240. In an embodiment, the heat dissipation substrate 251 is fastened to the heat conductor 240. For example, there is a solder layer between a hole wall of the through hole T2 of the heat conductor 240 and the heat dissipation substrate 251. In other words, the heat conductor 240 is fastened to the heat dissipation substrate 251 via the solder layer. In an aspect, the heat conductor 240 can be closely attached to the heat dissipation substrate 251, thereby shortening a heat conduction path between the heat dissipation substrate 251 and the heat conductor 240, and reducing a probability of an electrochemical reaction between the heat conductor 240 and the heat dissipation substrate 251. In addition, reliability of heat conduction between the heat dissipation substrate 251 and the heat conductor 240 is improved, and efficiency of heat conduction between the heat conductor 240 and the heat dissipation substrate 251 is improved.

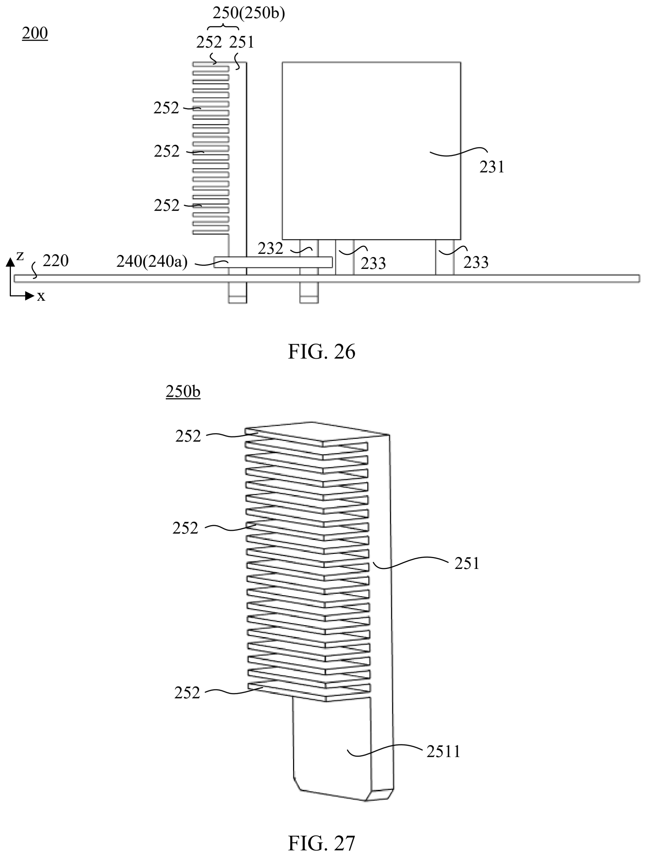

FIG. 27 is a diagram of a tooth-shaped heat sink according to an embodiment of this application. In an embodiment, as shown in FIG. 27, the heat dissipation substrate 251 includes a fastening end 2511, and the fastening end 2511 extends toward a side facing the circuit board 220 and passes through the heat conductor 240. Therefore, in a process of assembling the heat dissipation substrate 251 with the heat conductor 240, the fastening end 2511 of the heat dissipation substrate 251 can be used to implement positioning and pre-fastening of the heat dissipation substrate 251, so that the heat dissipation substrate 251 is subsequently fastened to the heat conductor 240.

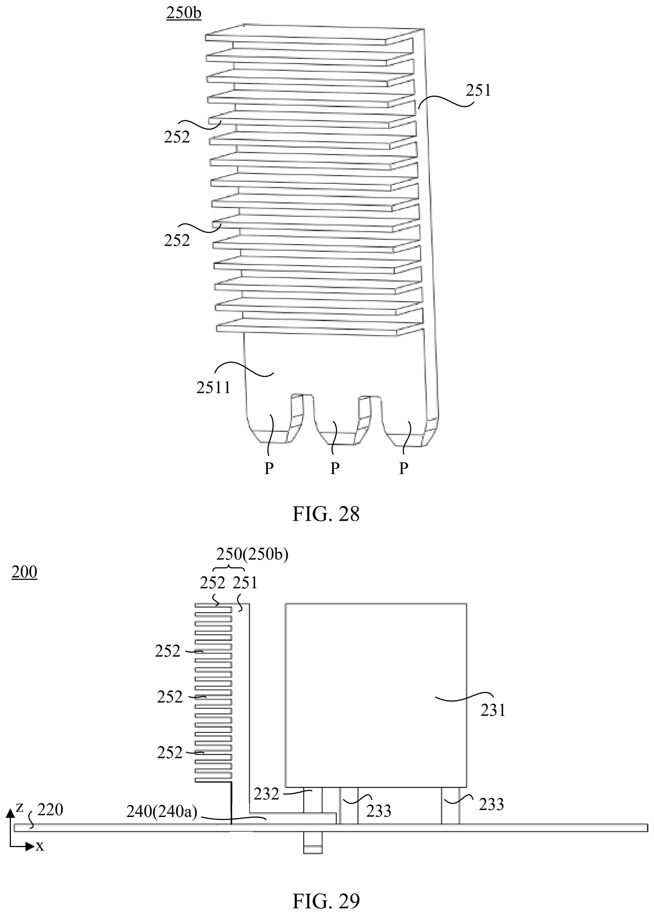

FIG. 28 is another diagram of a tooth-shaped heat sink according to an embodiment of this application. In an embodiment, as shown in FIG. 28, the heat dissipation substrate 251 includes a plurality of protrusions P that are spaced apart, and the protrusions P extend toward a side of the circuit board 220 and pass through the heat conductor 240. In this way, it is convenient for the heat dissipation substrate 251 to be separately soldered to the heat conductor 240 and the circuit board 220. In addition, the heat dissipation substrate 251 can be more firmly connected to the heat conductor 240, so that the heat conduction path between the heat dissipation substrate 251 and the heat conductor 240 can be shortened, thereby improving heat dissipation effect.

In an embodiment, as shown in FIG. 23 to FIG. 26, the heat dissipation substrate 251 passes through the circuit board 220. In this way, the heat dissipation substrate 251 can further dissipate heat on the circuit board 220, thereby further improving heat dissipation effect on the circuit board 220. In addition, space occupied by the heat dissipation substrate 251 and the circuit board 220 is also reduced, so that an internal structure of the power converter 200 is compact.

In an embodiment, the fastening end 2511 of the heat dissipation substrate 251 further passes through the circuit board 220. Therefore, in a process of assembling the heat dissipation substrate 251 with the circuit board 220, the fastening end 2511 of the heat dissipation substrate 251 can be used to implement positioning and pre-fastening of the heat dissipation substrate 251, so that the heat dissipation substrate 251 is subsequently fastened to the circuit board 220. In an embodiment, the protrusions P of the fastening end 2511 of the heat dissipation substrate 251 further pass through the circuit board 220. In this way, the heat dissipation substrate 251 can be more firmly connected to the circuit board 220, so that the heat conduction path between the heat dissipation substrate 251 and the circuit board 220 can be shortened, thereby improving heat dissipation effect.

In an embodiment, a material of the heat dissipation substrate 251 is the same as a material of the heat conductor 240. This can avoid affecting heat dissipation effect of the heat sink 250 due to poor contact caused by the electrochemical reaction between the heat dissipation substrate 251 and the heat conductor 240.

For example, both the material of the heat dissipation substrate 251 and the material of the heat conductor 240 are copper or aluminum.

In an embodiment, a material of the heat dissipation substrate 251 is the same as a material of the heat sink fin 252. For example, both the material of the heat dissipation substrate 251 and the material of the heat sink fin 252 are copper or aluminum.

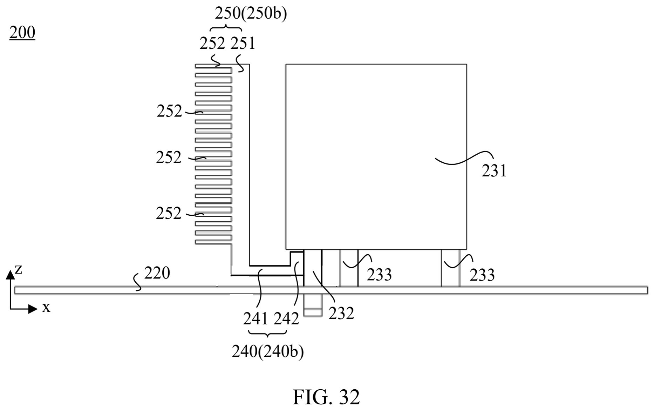

FIG. 29 to FIG. 32 each are another diagram of a power converter according to an embodiment of this application. In an embodiment, as shown in FIG. 29 and FIG. 32, when the heat conductor 240 is located between the relay housing 231 and the circuit board 220, the heat dissipation substrate 251 and the heat conductor 240 are of an integrated structure. In this way, reliability of heat conduction between the heat dissipation substrate 251 and the heat conductor 240 can be improved. In addition, no fastener needs to be disposed to fasten the heat dissipation substrate 251 to the heat conductor 240, thereby saving internal space of the power converter 200. Further, a manufacturing process of the power converter 200 can be simplified.

In some embodiments, the heat sink 250 includes both the heat dissipation panel 250a and the tooth-shaped heat sink 250b. The heat sink 250 of two different structures is disposed, so that space of the front surface and a side surface of the circuit board 220 in the power converter 200 can be fully used, and a heat dissipation area is increased, thereby improving heat dissipation effect of the heat sink 250.

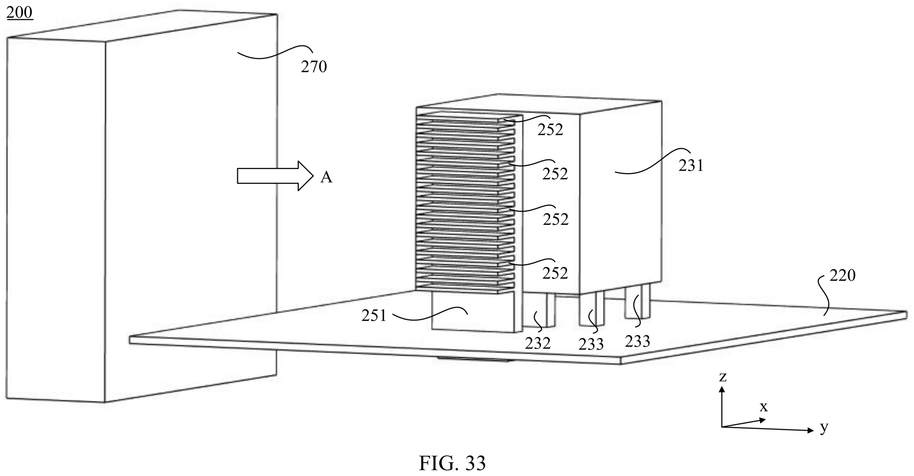

FIG. 33 is another diagram of a power converter according to an embodiment of this application. In an embodiment, as shown in FIG. 33, the power converter 200 further includes a fan 270. As shown in FIG. 2, the fan 270 is accommodated in the housing 210. A spacing between two adjacent heat sink fins 252 can be used as an air channel, and air blown out by the fan 270 flows through the air channel to take away heat on the heat sink fins 252, thereby improving heat dissipation efficiency of the heat sink 250.

In an embodiment, an air exhaust vent of the fan 270 faces the tooth-shaped heat sink 250b, and an orientation A of the air exhaust vent of the fan 270 is perpendicular to an arrangement direction of the plurality of heat sink fins 252 and an arrangement direction of the heat dissipation substrate 251 and the relay 230.

In an embodiment, as shown in FIG. 33, the orientation A of the air exhaust vent of the fan 270 is a y direction, the arrangement direction of the plurality of heat sink fins 252 is a z direction, and the arrangement direction of the heat dissipation substrate 251 and the relay 230 is an x direction. In an embodiment, the orientation A of the air exhaust vent of the fan 270 is a z direction, the arrangement direction of the plurality of heat sink fins 252 is a y direction, and the arrangement direction of the heat dissipation substrate 251 and the relay 230 is an x direction.

In an embodiment, after air blown from the air exhaust vent of the fan 270 passes through another component in the power converter 200, an orientation of the air flowing into the air channel between the two adjacent heat sink fins 252 is perpendicular to the arrangement direction of the plurality of heat sink fins 252 and the arrangement direction of the heat dissipation substrate 251 and the relay 230. For example, the another component may include an air duct in the power converter 200 or another component in the power converter 200.

In an embodiment, the power converter 200 further includes a connecting piece 280, and the connecting piece 280 is used to fasten the relay 230 to the tooth-shaped heat sink 250b. This prevents the tooth-shaped heat sink 250b from tilting, to ensure heat dissipation effect of the power converter 200.

In an embodiment, the connecting piece 280 is disposed on the relay 230.

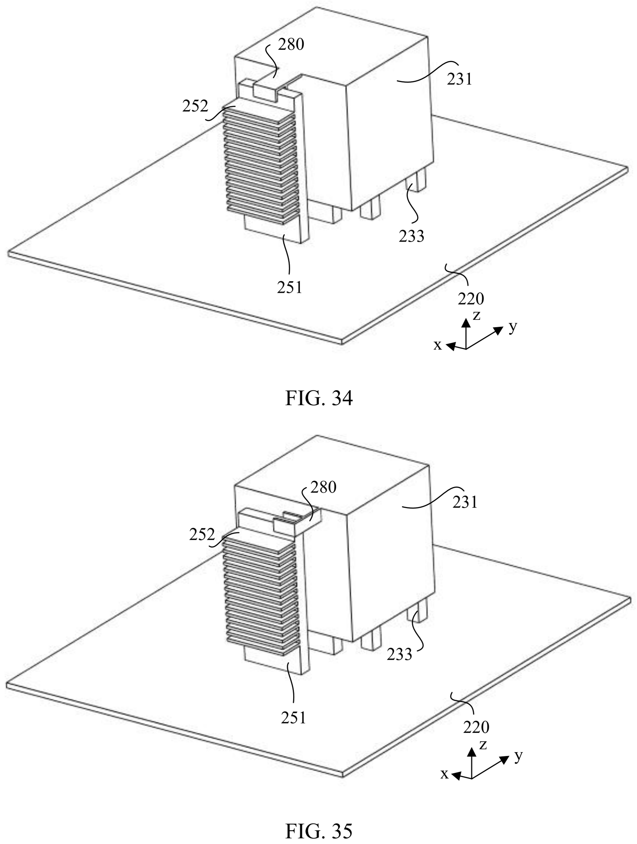

FIG. 34 to FIG. 36 each are another diagram of a power converter according to an embodiment of this application. In an example, as shown in FIG. 34 to FIG. 36, one end of the connecting piece 280 is fastened to the relay housing 231, and the other end of the connecting piece 280 is clamped to the heat dissipation substrate 251. For example, as shown in FIG. 34 to FIG. 36, the connecting piece 280 is a clamp. The relay 230 is detachably clamped to the toothed-shaped heat sink 250b via the connecting piece 280.

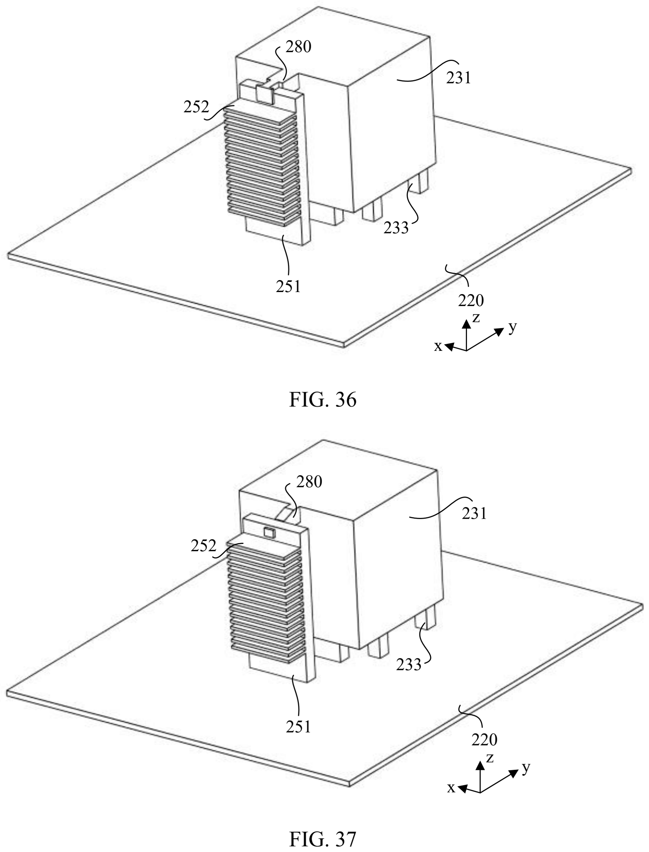

FIG. 37 is another diagram of a power converter according to an embodiment of this application. In an example, as shown in FIG. 37, one end of the connecting piece 280 is fastened to the relay housing 231, and the other end of the connecting piece 280 is embedded into the heat dissipation substrate 251. As shown in FIG. 37, the connecting piece 280 is a strip-shaped protrusion. The relay 230 is detachably embedded into the tooth-shaped heat sink 250b via the connecting piece 280.

In an embodiment, in a direction (namely, a z direction) in which the relay housing 231 is away from the circuit board 220, the connecting piece 280 is disposed at a middle position and a position above the middle of the relay housing 231. In this way, the connecting piece 280 on the relay housing 231 is clamped to or embedded into a middle position and a position above the middle of the heat dissipation substrate 251, thereby improving a tilt resistance capability of the heat dissipation substrate 251.

It should be understood that the middle position of the relay housing 231 is a position flush with a center line of the relay housing 231 in the direction in which the relay housing 231 is away from the circuit board 220. Similarly, the middle position of the heat dissipation substrate 251 is a position flush with a center line of the heat dissipation substrate 251 in the direction in which the heat dissipation substrate 251 is away from the circuit board 220.

In addition, the position above the middle of the relay housing 231 is a position above the center line of the relay housing 231 in the direction in which the relay housing 231 is away from the circuit board 220. Similarly, the position above the middle of the heat dissipation substrate 251 is a position above the center line of the heat dissipation substrate 251 in the direction in which the heat dissipation substrate 251 is away from the circuit board 220.

It should be noted that the middle position of the relay housing 231 or the heat dissipation substrate 251 is not a middle position in a strict sense, but is within an allowable error range.

For example, as shown in FIG. 34 to FIG. 36, the connecting piece 280 is clamped to the top of the heat dissipation substrate 251. As shown in FIG. 35, the clamp is clamped to a side of the heat dissipation substrate 251. As shown in FIG. 37, the connecting piece 280 is embedded into the heat dissipation substrate 251.

In an embodiment, as shown in FIG. 34 to FIG. 37, one end of the connecting piece 280 is fastened to a surface that is of the relay housing 231 and that faces the heat dissipation substrate 251. In other words, the connecting piece 280 extends toward the heat dissipation substrate 251 from the surface that is of the relay housing 231 and that faces the heat dissipation substrate 251, and the connecting piece 280 is arranged by fully using space between the heat dissipation substrate 251 and the relay housing 231, so that a structure between the tooth-shaped heat sink 250b and the relay 230 is compact, thereby occupying less space by the power converter 200.

In an embodiment, the connecting piece 280 is disposed on the tooth-shaped heat sink 250b.

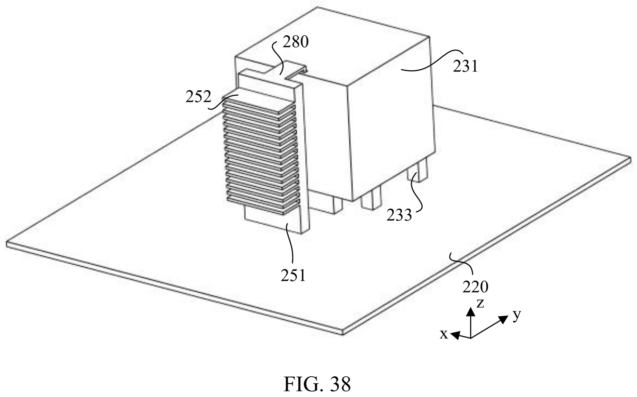

FIG. 38 is another diagram of a power converter according to an embodiment of this application. In an example, as shown in FIG. 38, one end of the connecting piece 280 is fastened to the heat dissipation substrate 251, and the other end of the connecting piece 280 is clamped to the relay housing 231. For example, as shown in FIG. 38, the connecting piece 280 is a hook. The tooth-shaped heat sink 250b is detachably clamped to the relay 230 via the connecting piece 280.

In an example, one end of the connecting piece 280 is fastened to the heat dissipation substrate 251, and the other end of the connecting piece 280 is embedded into the relay housing 231. For example, the connecting piece 280 is a strip-shaped protrusion. The tooth-shaped heat sink 250b is detachably embedded into the relay 230 via the connecting piece 280.

In an embodiment, in a direction (namely, a z direction) in which the heat dissipation substrate 251 is away from the circuit board 220, the connecting piece 280 is disposed at a middle position and a position above the middle of the heat dissipation substrate 251. In this way, the connecting piece 280 on the heat dissipation substrate 251 is clamped to or embedded into a middle position and a position above the middle of the relay housing 231, thereby improving a tilt resistance capability of the heat dissipation substrate 251.

In an embodiment, as shown in FIG. 38, one end of the connecting piece 280 is fastened to a surface that is of the heat dissipation substrate 251 and that faces the relay housing 231. In other words, the connecting piece 280 extends toward the relay housing 231 from the surface that is of the heat dissipation substrate 251 and that faces the relay housing 231, and the connecting piece 280 is arranged by fully using space between the heat dissipation substrate 251 and the relay housing 231, so that a structure between the tooth-shaped heat sink 250b and the relay 230 is compact, thereby occupying less space by the power converter 200.

In an embodiment, as shown in FIG. 38, the connecting piece 280 is embedded into a surface that is of the relay housing 231 and that is away from the circuit board 220. In other words, the connecting piece 280 is embedded into an upper surface of the relay housing 231. In this way, in a process in which the tooth-shaped heat sink 250b is inserted into the circuit board 220 from top to bottom, the connecting piece 280 on the heat dissipation substrate 251 of the tooth-shaped heat sink 250b can be fastened to the relay housing 231, thereby improving assembly efficiency of the power converter 200.

An embodiment of this application provides a relay heat dissipation apparatus. The relay heat dissipation apparatus includes a circuit board, a relay, a heat conductor, and a heat sink. The relay is mounted on the circuit board. The relay is configured to perform on-grid and off-grid switching of the power converter, the relay includes a relay housing, a fixed contact, and a pin, the fixed contact is located in the relay housing, one end of the pin is connected to the fixed contact, and the other end of the pin is fastened and electrically connected to the circuit board. The heat conductor and the relay are located on a same side or opposite sides of the circuit board. The heat conductor is separately in contact with the pin and the heat sink, to conduct heat on the pin to the heat sink and dissipate the heat.

For content that is not described in the circuit board, the relay, the heat conductor, and the heat sink in the relay heat dissipation apparatus, refer to the foregoing related descriptions of the power converter 200. Details are not described herein again.

In an embodiment, the relay heat dissipation apparatus may also include a fan. For related descriptions of the fan, refer to the foregoing related descriptions of the power converter 200. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, wherein the power converter comprises a circuit board, a DC/AC circuit, and a relay, wherein
the DC/AC circuit and the relay are mounted on the circuit board;
the DC/AC circuit is configured to convert a direct current from a photovoltaic module or an energy storage battery into an alternating current, and an alternating current end of the DC/AC circuit is electrically connected to the relay;
the relay is configured to perform on-grid and off-grid switching of the power converter, the relay comprises a relay housing, a fixed contact, and a pin, the fixed contact is located in the relay housing, one end of the pin is connected to the fixed contact, and the other end of the pin is fastened and electrically connected to the circuit board; and
the power converter further comprises a heat conductor and a heat sink, the heat conductor and the relay are located on a same side or opposite sides of the circuit board, and the heat conductor is separately in contact with the pin and the heat sink, to conduct heat on the pin to the heat sink and dissipate the heat.

2. The power converter according to claim 1, wherein a surface that is of the heat conductor and that faces the circuit board is bonded or soldered to the circuit board, to conduct heat on the circuit board to the heat sink and dissipate the heat.

3. The power converter according to claim 2, wherein the heat conductor is a metal layer on a surface of the circuit board.

4. The power converter according to claim 1 or 2, wherein the heat conductor comprises a first part and a second part that are connected, the first part is attached to the circuit board, and the second part extends toward a side away from the circuit board and is attached to the pin.

5. The power converter according to claim 2 or 4, wherein the heat conductor comprises a fastening cradle, the fastening cradle extends toward a side facing the circuit board, and the fastening cradle is configured to be embedded into the circuit board.

6. The power converter according to any one of claims 1 to 5, wherein when the heat conductor is located between the relay housing and the circuit board, there is a spacing between the heat conductor and the relay housing in an arrangement direction of the relay and the circuit board.

7. The power converter according to claim 6, wherein the relay further comprises a support cradle, the support cradle is located on a side that is of the relay housing and that faces the circuit board, and the support cradle passes through the heat conductor and abuts against the circuit board.

8. The power converter according to any one of claims 1 to 5, wherein when the heat conductor is located on a side that is of the circuit board and that is away from the relay, the other end of the pin passes through the circuit board and is in contact with the heat conductor.

9. The power converter according to claim 1, wherein the heat conductor is located inside the circuit board, and the heat conductor is a metal layer.

10. The power converter according to any one of claims 1 to 9, wherein the heat sink comprises a heat dissipation substrate and a plurality of heat sink fins, the heat dissipation substrate and the relay are spaced apart, the plurality of heat sink fins are fastened to a surface that is of the heat dissipation substrate and that is away from the relay, and the heat dissipation substrate is in contact with the heat conductor, to dissipate, via the plurality of heat sink fins, the heat conducted by the heat conductor from the pin.

11. The power converter according to claim 10, wherein the plurality of heat sink fins are arranged in a direction perpendicular to the circuit board, and the heat sink fins extend in a direction perpendicular to the heat dissipation substrate.

12. The power converter according to any one of claims 10 or 11, wherein the power converter comprises a connecting piece, wherein
one end of the connecting piece is fastened to the relay housing, the other end of the connecting piece is clamped to or embedded into the heat dissipation substrate, and the connecting piece is disposed at a middle position and a position above the middle of the relay housing in a direction in which the relay housing is away from the circuit board; or
one end of the connecting piece is fastened to the heat dissipation substrate, the other end of the connecting piece is clamped to or embedded into the relay housing, and the connecting piece is disposed at a middle position and a position above the middle of the heat dissipation substrate in a direction in which the heat dissipation substrate is away from the circuit board.

13. The power converter according to claim 8, wherein the heat sink comprises a heat dissipation panel, and the heat dissipation panel is located on a side that is of the heat conductor and that is away from the circuit board, wherein
the heat dissipation panel comprises an internal flow channel, and the internal flow channel is used to transfer a cooling medium to dissipate the heat conducted by the heat conductor from the pin.

14. The power converter according to claim 13, wherein the power converter further comprises a thermally conductive connection layer, the thermally conductive connection layer is located between the heat conductor and the heat dissipation panel, hardness of the thermally conductive connection layer is less than hardness of the heat conductor and hardness of the heat dissipation panel, the other end of the pin passes through the heat conductor and is embedded into the thermally conductive connection layer, and the heat conductor is configured to conduct, to the heat dissipation panel via the thermally conductive connection layer, the heat conducted by the heat conductor from the pin.

15. A relay heat dissipation apparatus, wherein the relay heat dissipation apparatus comprises:
a circuit board and a relay, wherein the relay is mounted on the circuit board, the relay is configured to perform on-grid and off-grid switching of the power converter, the relay comprises a relay housing, a fixed contact, and a pin, the fixed contact is located in the relay housing, one end of the pin is connected to the fixed contact, and the other end of the pin is fastened and electrically connected to the circuit board; and
a heat conductor and a heat sink, wherein the heat conductor and the relay are located on a same side or opposite sides of the circuit board, and the heat conductor is separately in contact with the pin and the heat sink, to conduct heat on the pin to the heat sink and dissipate the heat.
